# EUROPEAN PATENT APPLICATION

(11) **EP 1 458 017 A1**
(43) Date of publication of application: **15.09.2004**
(21) Application number: 02790794.8
(22) Date of filing: 18.12.2002
(51) Int. Cl.: H01L 21/322

(54) **SILICON WAFER AND METHOD FOR PRODUCTION OF SILICON WAFER**

(30) Priority: 18.12.2001 JP 2001384755
(71) Applicant: Komatsu Denshi Kinzoku Kabushiki Kaisha, Hiratsukashi, Kanagawa 254-0014 (JP)
(72) Inventor: IGA, Hisao, KOMATSU DENSHI KINZOKU K. K., Hiratsuka-shi, Kanagawa 254-0014 (JP); KITAGAWA, Satoshi, KOMATSU DENSHI KINZOKU K. K., Hiratsuka-shi, Kanagawa 254-0014 (JP)
(74) Representative: Reinhardt, Markus, Dipl.-Ing.
(86) International application number: PCT/JP2002/013214
(87) International publication number: WO 2003/052811

(57) **Abstract**

A silicon wafer, which has been doped with nitrogen and has been subjected to an extrinsic gettering (EG) treatment, for example, the formation of a polysilicon layer. In the silicon wafer, when the wafer is exposed to an ion of a heavy metal such as copper or nickel in a device manufacturing process, the copper and nickel can be captured by the action of intrinsic gettering (IG) in the course of a heat treatment, and, when a polysilicon layer is formed as a strain layer, iron and copper can be captured by the action of an extrinsic gettering (EG) using the polysilicon as a strong point for the capture.

## Description

### TECHNOLOGICAL FIELD

The present invention relates to a silicon wafer and a method for manufacturing a silicon wafer. More particularly, the present invention relates to a silicon wafer, which is capable of preventing a contamination of heavy metal ions therein, and a manufacturing method thereof.

### BACKGROUND ART

Semiconductor devices are typically manufactured via a device manufacturing process for forming device layers on the surface of the silicon wafer by a thin film, diffusion or the like.

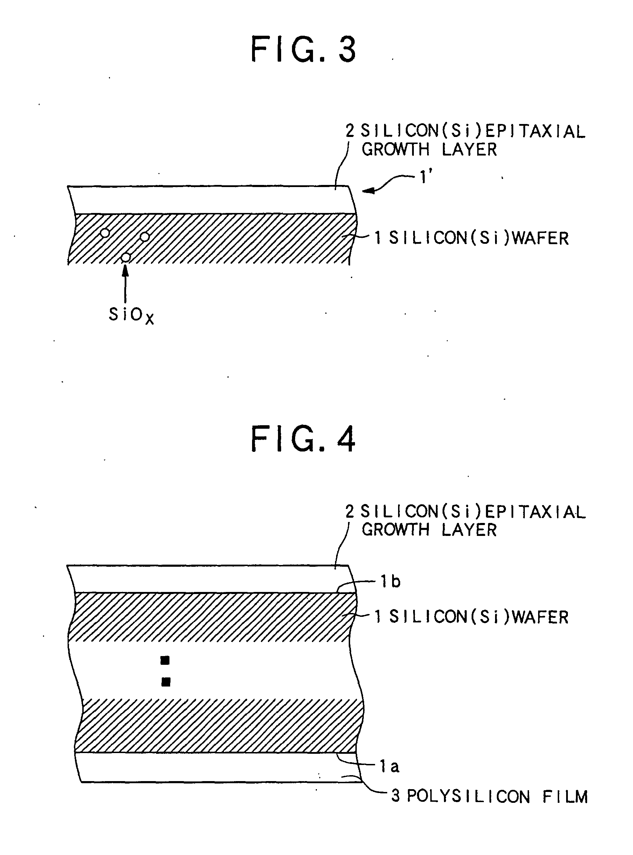

Fig. 3 is a cross sectional view of a silicon wafer 1' in which an epitaxial growth layer 2 is formed on a silicon wafer substrate 1, assuming that the wafer is a silicon (Si) wafer.

The silicon wafer 1' is doped with boron B as an impurity (dopant). The silicon wafer 1' is a p/p- silicon wafer doped with the impurity B of relatively low concentration. Inside the furnace of an epitaxial growth apparatus, feed gases for a thin film such as trichlorosilane (SiHCl₃) is supplied onto the surface 1a of the silicon substrate 1 together with a small amount of boron B. Chemical reaction of trichlorosilane is then induced on the surface of the silicon substrate 1 to form a thin film 2 of the same silicon thereon by epitaxial growth.

By the above operations, a crystal having the same atomic arrangement as in the silicon substrate 1 is formed on the substrate 1.

In general, the silicon wafer 1' is contaminated with heavy metals such as iron, copper, nickel or the like in the device manufacturing process conducted thereafter. When heavy metal ions such as iron ions or the like are migrated into the device layer of the silicon wafer 1' during the device manufacturing process, the resultant devices may possibly perform false operations, and as a result may have a short life.

Therefore, a gettering treatment is conventionally conducted so as to avoid the migration of heavy metal ions into the device layer of the silicon wafer 1'.

The gettering treatment includes an intrinsic gettering (hereinafter abbreviated as "IG") and an extrinsic gettering (hereinafter abbreviated as "EG").

The IG is a gettering technique, in which a heat treatment is conducted on the silicon wafer to precipitate a defect, which is referred to as a bulk micro defect (BMD), in the bulk of the silicon wafer, and in turn, a heavy metal impurity is captured with the BMD as a strong point for the capture.

Fig. 4 illustrates the IG.

The silicon wafer 1', which is grown by the Czochralski method (CZ method), contains oxygen that is eluted from a quartz crucible during the manufacturing process of a silicon ingot. Then, heat treatment is conducted over the silicon wafer 1' in the device manufacturing process, so that silicon oxide (SiOx) is precipitated in the bulk thereof. Silicon oxide (SiOx) acquires a gettering ability when a precipitated nucleus thereof is grown to have a predetermined size, that is approximately several tens nm in diameter. Such precipitated nucleus of silicon oxide (SiOx) having the gettering ability is referred to as BMD. Since silicon oxide (SiOx) has a larger volume than single crystalline silicon of the same atomic weight concentration, the precipitated BMD generates a local distortion in the bulk. When the same heat treatment is performed, the higher the concentration of the BMD is, the greater the gettering effect becomes. Also, the higher the concentration of boron as a dopant is, the higher the concentration of the BMD becomes.

On the other hand, the EG is a gettering technique, in which a strain layer is formed by intentionally applying a mechanical strain to the backside of the silicon wafer or forming the polysilicon layer thereon, and heavy metal impurities are captured using the strain layer as a strong point for the capture.

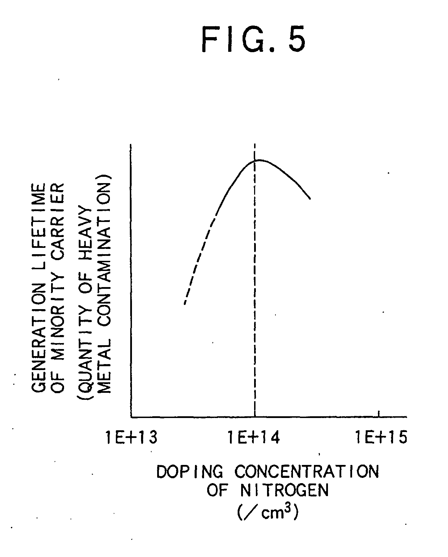

Fig. 5 is a cross sectional view of a layer structure, illustrating the EG, in which a strain layer is provided by forming the polysilicon layer.

The steps for forming the polysilicon layer are as follows.
a) Placing the silicon substrate 1 within a furnace.
b) Performing the Chemical Vapor Deposition (CVD) or the like on the silicon substrate 1 to form a polysilicon layer 3 so as to cover the entire body of the substrate.
c) Polishing off the polysilicon layer 3 on the surface 1b of the silicon substrate 1 and then cleaning the entire body thereof to obtain the silicon substrate in which the polysilicon layer 3 is formed only on the back surface 1a thereof.

Alternatively, polysilicon layer 3 may be formed only on the back surface 1a of the silicon substrate 1 by introducing silane gas only onto the back surface 1a.

When an epitaxial growth film 2 is grown on the silicon substrate 1, the BMD precipitation nucleus is disappeared, so that the concentration of BMD is decreased even if the heat treatment is performed thereafter, thereby reducing the gettering ability thereof In addition, since higher concentration of boron as dopant results in higher concentration of BMD, the concentration of the BMD in the p/p- silicon wafer 1' doped with boron of a low concentration is decreased, thereby reducing the gettering ability thereof.

As such, the silicon wafer 1' doped with boron of a low concentration and having an epitaxial growth film 2 formed thereon has a problem of lower gettering ability.

An attempt of facilitating the precipitation of the BMD has been made, in which a heat treatment is performed before the epitaxial growth film 2 is formed so as to grow large precipitation nucleus of silicon oxide SiOx, thereby facilitating the BMD precipitation. However, this attempt has a problem that the heat treatment requires a long time, and thus the manufacturing cost of silicon wafer is increased.

Thus, researches and developments have been made to increase the BMD concentration by doping nitrogen into the silicon substrate 1.

On the other hand, since the above-mentioned steps (a) to (c) should be carried out for performing the EG treatment on the silicon wafer 1', the steps for manufacturing the wafers become complicated, thereby requiring longer time, and thus the manufacturing cost is increased. Nevertheless, the EG provides higher gettering ability for the p/p-silicon wafer 1' doped with boron of a low concentration, compared with the IG. Therefore, the EG has been the common treatment for the silicon wafer formed with the epitaxial growth film.

However, the situation of insufficient gettering ability has arisen in both the IG that additionally includes the nitrogen doping process and the EG treatment. This problem has not been solved in the existing circumstances.

### DISCLOSURE OF THE INVENTION

In view of the above situation, the present invention provides a solution to the above-mentioned problem, and it is an object of the present invention to provide a technology for improving the gettering ability of heavy metal ions.

Thus, first aspect of the present invention is characterized in that A silicon wafer is doped with an element that facilitates a precipitation of a bulk micro defect (BMD) and is subjected to an extrinsic gettering (EG) treatment.

Second aspect of the present invention is characterized in that the element comprises one of nitrogen and carbon, or both nitrogen and carbon, in addition to first aspect of the present invention.

Third aspect of the present invention is characterized in that the wafer is doped with boron of a low concentration, in addition to first aspect of the present invention.

Fourth aspect of the present invention is characterized in that an epitaxial growth layer is formed thereon, in addition to first aspect of the present invention.

Fifth aspect of the present invention is characterized in that a silicon wafer is doped with nitrogen so as to increase a concentration of BMD to such an extent that an intrinsic gettering (IG) is conducted for, at least, nickel, and which is subjected to an extrinsic gettering (EG) treatment to such an extent that gettering of iron and copper is effected.

Sixth aspect of the present invention is characterized in that a method for manufacturing a silicon wafer comprises doping a silicon wafer with an element that facilitates a precipitation of BMD; and performing an extrinsic gettering (EG) treatment to the silicon wafer.

Seventh aspect of the present invention is characterized in that a method for manufacturing a silicon wafer comprises doping a silicon wafer with an element that facilitates a precipitation of BMD together with boron of a low concentration; and performing an extrinsic gettering (EG) treatment to the silicon wafer.

Eighth aspect of the present invention is characterized in that a method for manufacturing a silicon wafer comprises doping a silicon wafer with an element that facilitates a precipitation of BMD; performing an extrinsic gettering (EG) treatment to the silicon wafer; and forming an epitaxial growth layer on the silicon wafer.

Ninth aspect of the present invention is characterized in that a method for manufacturing a silicon wafer comprises doping a silicon wafer with an element that facilitates a precipitation of BMD together with boron of a low concentration; performing an extrinsic gettering (EG) treatment to the silicon wafer; and forming an epitaxial growth layer on the silicon wafer.

Tenth aspect of the present invention is characterized in that A method for manufacturing a silicon wafer comprises doping a silicon wafer with nitrogen so as to increase a concentration ofBMD to such an extent that an intrinsic gettering (IG) is conducted for, at least, nickel; and performing an extrinsic gettering (EG) treatment to the silicon wafer to such an extent that gettering of iron and copper is effected.

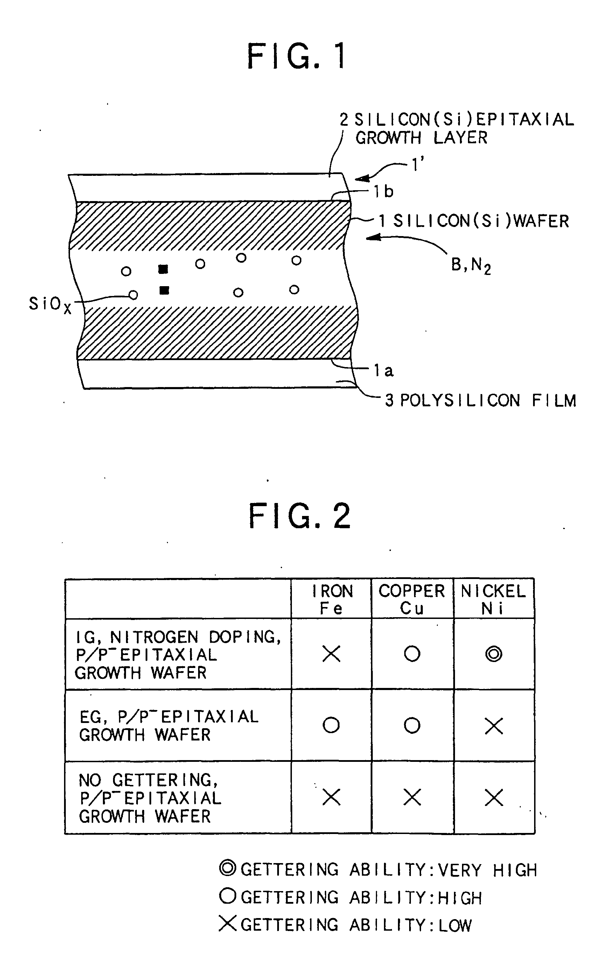

According to the present invention, as shown in Fig. 1, the silicon wafer 1' is subjected to a nitrogen doping process, the nitrogen being as an element of facilitating BMD precipitation, and also subjected to an extrinsic gettering (EG) treatment, for example, a process of forming a polysilicon layer 3. Therefore, even if the silicon wafer is exposed to heavy metal ions such as copper, nickel or the like during the device manufacturing process, the intrinsic gettering (IG) acts during the the heat treatment, and thus copper and nickel can be captured (see Fig. 2). In addition, since the polysilicon layer 3 is formed as a strain layer, iron and copper can be captured using the polysilicon layer 3 as a strong point for the capture with the action of the extrinsic gettering (EG)(see Fig. 2). Thus, according to the present invention, sufficient gettering of various heavy metal ions such as iron, copper, nickel or the like generated during the device manufacturing process, can be achieved. Therefore, migrations of heavy metal ions such as iron, copper, nickel or the like into the device layer of the silicon wafer 1' can be avoided, thereby to prevent malfunctions of the device, and to effect a longer product life.

### BRIEF DESCRIPTION OF DRAWINGS

Fig. 1 is a cross sectional view of a silicon wafer according to an embodiment of the present invention;
Fig. 2 is a table showing relationships of the gettering abilities between the intrinsic gettering (IG) that additionally includes the nitrogen doping process and the extrinsic gettering (EG) treatment with respect to various heavy metal ions;
Fig. 3 is a cross sectional view of the silicon wafer, for use in describing the intrinsic gettering (IG);
Fig. 4 is a cross sectional view of the silicon wafer, for use in describing the extrinsic gettering (EG); and
Fig. 5 is a graph showing a relationship of the nitrogen doping concentration with the generation lifetime of minority carriers.

### DETAILED DESCRIPTION OF THE PREFERRED EMBODIMENT

A semiconductor wafer and a method for manufacturing a semiconductor wafer according to embodiment of the present invention will be described in reference to the accompanying drawings.

In the embodiment described below, a silicon wafer is employed as the semiconductor wafer.

In view of the situation in which the gettering abilities is insufficient in both the IG additionally including the nitrogen doping process and the EG treatment, the present inventors have conducted the analysis on the basis of the assumption that the gettering abilities of the EG and the IG vary depending on the type of heavy metal ions. The results of the analysis are shown Fig. 2. Here, the silicon wafer that was analyzed was a p/p- silicon wafer 1' doped with boron of a low concentration. The term "low concentration" is meant to be a concentration of boron within a range of approximately from 3 x 10¹⁴ /cm³ to 1 x 10¹⁶ /cm³ (1 Ω-cm to 15 Ω-cm).

Fig. 2 shows the results obtained by the analysis indicating that the gettering ability was low for iron, high for copper and very high for nickel in the IG additionally including the nitrogen doping process.

On the other hand, the obtained analysis results also indicate that the gettering ability was low for nickel and high for iron and copper in the EG. In the p/p- silicon wafer 1' to which neither the IG treatment nor the EG treatment was conducted, the gettering ability was low for iron, copper and nickel.

From the above-described results, the conclusion was obtained that both the IG additionally including the nitrogen doping process and the EG treatment should be employed to treat the silicon wafer 1', in order to obtain sufficiently higher gettering ability for each of the heavy metal ions of iron, copper and nickel.

Fig. 1 illustrates a cross sectional view of the silicon wafer 1' according to the present embodiment. The silicon wafer 1' is manufactured as follows.

First, a silicon melt containing boron B and nitrogen N is molten in a quartz crucible to grow a silicon ingot containing (or doped with) impurities (dopants) of boron B of a low concentration and nitrogen N.

Silicon ingot is sliced to obtain a silicon substrate 1. Thus, a p-type silicon substrate doped with impurity B of a low concentration is obtained.

Then, a polysilicon layer 3 is formed for the purpose of acquiring sufficient gettering ability for iron and copper in EG.

The steps for forming the polysilicon layer 3 are as follows.
a) Placing the silicon substrate 1 within a furnace.
b) Performing the Chemical Vapor Deposition (CVD) or the like on the silicon substrate 1 to form a polysilicon layer 3 so as to cover the entire body of the substrate.
c) Polishing off the polysilicon layer 3 on thesurface 1b of the silicon substrate 1 and then cleaning the entire body thereof to obtain the silicon substrate in which the polysilicon layer 3 is formed only on the back surface 1a thereof.

Alternatively, the polysilicon layer 3 may be formed only on the back surface 1a of the silicon substrate 1 by introducing silane gas only onto the back surface 1a.

Then, a feed gas for depositing a thin film such as trichlorosilane (SiHCl₃), for example, are supplied onto the surface 1a of the silicon substrate 1 disposed in the furnace of the epitaxial growth apparatus. Chemical reaction of trichlorosilane is then induced on the surface 1b of the silicon substrate 1 to form a same silicon film 2 thereon via epitaxial growth.

By the above-described processes, a crystal having the same atomic arrangement as that of the silicon substrate 1 is formed on the substrate 1.

When the silicon wafer 1' thus manufactured is subjected to the heat treatment in the device manufacturing process that is to be conducted later, a precipitation nucleus of silicon oxide (SiOx) grows in the bulk up to the size larger than a predetermined size (typically having a diameter of several tens nm), thereby to precipitate BMD. Here, since the silicon wafer 1' has been doped with nitrogen in advance, BMD concentration is high, so that the gettering ability for copper and nickel is high as indicated in Fig. 2.

Even if the manufactured silicon wafer 1' is exposed to heavy metal ions such as iron, copper or the like during the device manufacturing process, these heavy metal ions can be captured with sufficiently higher gettering ability by utilizing the polysilicon layer 3 as a strain layer, as indicated in Fig. 2.

According to the embodiment described above, the silicon wafer 1' is subjected to the nitrogen doping process and to the extrinsic gettering (EG) treatment. Therefore, even if the silicon wafer is exposed to heavy metal ions such as copper, nickel or the like during the device manufacturing process, the intrinsic gettering (IG) acts during the heat treatment, and thus these copper and nickel can be captured. In addition, since the polysilicon layer 3 is formed as a strain layer, with the action of the extrinsic gettering (EG), the iron and copper can be captured using the polysilicon layer 3 as a strong point for the capture. Thus, according to the present embodiment, sufficient gettering of various heavy metal ions such as iron, copper, nickel or the like generated in the device manufacturing process can be effected. Therefore, migrations of heavy metal ions such as iron, copper, nickel or the like into the device layer of the silicon wafer 1' can be avoided, thereby to prevent malfunctions of the device, and to make the life of the device long.

It should be noted that, as indicated in Fig. 2, both the EG and the IG provide the gettering ability for copper, and the gettering ability for nickel is higher than that for copper in the IG. Therefore, when the silicon wafer 1' is doped with nitrogen, it is possible to perform the doping of nitrogen of such a concentration level that provides the gettering ability for, at least, nickel.

Fig. 5 is a graph with the abscissa for the doping concentration of nitrogen (/cm³) and the ordinate for the generation lifetime of minority carrier. It can be seen from the graph that the larger the generation lifetime of minority carrier is, the smaller the quantity of the metal contamination becomes. As illustrated in Fig. 5, it can be seen that the quantity of the metal contamination is the smallest at the nitrogen concentration of 1E+14 (/cm³). It should be noted that the generation lifetime of minority carrier was below the measurement limitation when no nitrogen is doped.

In the above-described embodiment, the ability of the IG is enhanced by facilitating the precipitation of BMD with the doping of nitrogen. Alternatively, carbon may be employed in place of nitrogen to facilitate the precipitation of the BMD. Further, the precipitation of the BMD may be facilitated by doping both nitrogen and carbon.

Although the above-described embodiment assumes a method of forming the polysilicon layer 3 as a strain layer for the EG, similar effect can also be obtained by another method of forming a mechanical strain layer by conducting a sand blast treatment on the back surface 1a of the silicon wafer 1'.

Further, the embodiment stated above assumes the silicon wafer 1' doped with boron of low concentration, which is particularly effective in achieving the advantageous effect according to the present invention. However, the present invention can, of course, be also applied to the silicon wafer doped with boron of higher density.

### INDUSTRIAL APPLICABILITY

The present invention is applicable for a silicon wafer doped with an impurity other than boron.

## Claims

1. A silicon wafer, which is doped with an element that facilitates a precipitation of a bulk micro defect (BMD) and is subjected to an extrinsic gettering (EG) treatment.

2. The silicon wafer according to claim 1, wherein the element comprises one of nitrogen and carbon, or both nitrogen and carbon.

3. The silicon wafer according to claim 1, wherein the wafer is doped with boron of a low concentration.

4. The silicon wafer according to claim 1, wherein an epitaxial growth layer is formed thereon.

5. A silicon wafer, which is doped with nitrogen so as to increase a concentration of BMD to such an extent that an intrinsic gettering (IG) is conducted for, at least, nickel, and which is subjected to an extrinsic gettering (EG) treatment to such an extent that gettering of iron and copper is effected.

6. A method for manufacturing a silicon wafer, comprising:
doping a silicon wafer with an element that facilitates a precipitation of BMD; and
performing an extrinsic gettering (EG) treatment to the silicon wafer.

7. A method for manufacturing a silicon wafer, comprising:
doping a silicon wafer with an element that facilitates a precipitation of BMD together with boron of a low concentration; and
performing an extrinsic gettering (EG) treatment to the silicon wafer.

8. A method for manufacturing a silicon wafer, comprising:
doping a silicon wafer with an element that facilitates a precipitation ofBMD;
performing an extrinsic gettering (EG) treatment to the silicon wafer; and
forming an epitaxial growth layer on the silicon wafer.

9. A method for manufacturing a silicon wafer, comprising:
doping a silicon wafer with an element that facilitates a precipitation of BMD together with boron of a low concentration;
performing an extrinsic gettering (EG) treatment to the silicon wafer; and
forming an epitaxial growth layer on the silicon wafer.

10. A method for manufacturing a silicon wafer, comprising:
doping a silicon wafer with nitrogen so as to increase a concentration ofBMD to such an extent that an intrinsic gettering (IG) is conducted for, at least, nickel; and
performing an extrinsic gettering (EG) treatment to the silicon wafer to such an extent that gettering of iron and copper is effected.
